# EUROPEAN PATENT SPECIFICATION

(11) **EP 3 506 048 B1**
(45) Date of publication and mention of the grant of the patent: **31.03.2021**
(21) Application number: 18184928.2
(22) Date of filing: 23.07.2018
(51) Int. Cl.: G06F 1/20, G06F 1/16, H05K 7/20, H05K 5/02

(54) **ELECTRONIC DEVICE**
ELEKTRONISCHE VORRICHTUNG
DISPOSITIF ÉLECTRONIQUE

(30) Priority: 26.12.2017 TW 106145833
(43) Date of publication of application: 03.07.2019
(73) Proprietor: Acer Incorporated, New Taipei City 221 (TW)
(72) Inventor: CHEN, Hung-Chi, New Taipei City 221, (TW); PENG, Hsueh-Chih, New Taipei City 221 (TW); CHEN, Shun-Bin, New Taipei City 221, (TW); CHUANG, Huei-Ting, New Taipei City 221, (TW); HUANG, Pao-Min, New Taipei City 221, (TW)
(74) Representative: Haseltine Lake Kempner LLP

(56) References cited:
- CN-A- 101 727 127
- CN-A- 103 576 810
- US-A1- 2015 016 057

## Description

### BACKGROUND

### Technical Field

The invention is related to an electronic device, especially to an electronic device comprising a rotate-to-support structure.

### Description of Related Art

With rapid development of technology, requirement for electronic devices has increased in recent years. With the improved performance of electronic devices, heat generated by electronic components used in the electronic devices have increased accordingly. For example, regarding gaming laptops having demands for high performance computing, under the preconditions of thinness and easy mobility, the electronic elements with high performance need to be disposed in a space which is light and thin. It is a focus of such product designing to ensure sufficient heat dissipation effects of notebook computers while users perform game software with high performance computing demands.

Currently the heat dissipation for gaming laptops usually requires a combination of passive heat dissipation elements and active heat dissipation mechanism. Passive heat dissipation elements include cooling pads for notebook, notebook heat dissipation shelves and the like, and mainly serve to lift a notebook computer, such that airflow may flow between the notebook computer and a desktop to transfer heat generated by electronic elements to the outside of an electronic device, thereby reducing the temperature of the entire electronic device. However, the cooling pads, heat pads, heat dissipation shelves and the like take time to be adjusted when heat dissipation is needed, and they are not portable.

Some background information may be found in United States patent application US 2015/016057 and Chinese patent applications CN 101 727 127 and CN 103 576 810 US 2015/016057 A1 describes an electronic device with a foot cushion member coupled to a shape memory material member (SMM). When heat is applied to the SMM member it expands, extending the foot cushion member from the housing. CN 101727127 A describes an electronic device having a case with an opening in the bottom surface. A pivotable member in the opening has a connecting end attached via a wire to a shape memory alloy (SMA) member, which is attached by a wire on the other side to a fixing post. The SMA member is deformed by the thermal energy generated by electronic components, and causes the pivotable member to protrude from the bottom surface. CN 103576810A describes an electronic device having a body and a rectangular shape memory alloy (SMA) component disposed in a heat dissipation opening. When the SMA component is heated and exceeds a critical temperature, the SMA component is deformed and protrudes from the surface, forming a channel with the body.

### SUMMARY

An electronic device provided in the invention includes an mechanism of shape memory which may automatically transform to lift the electronic device subjected to a high temperature, thereby providing a heat dissipation airflow path to the electronic device.

An electronic device according to the invention includes a body and a shape memory element. The body includes an opening at a bottom surface of the electronic device. The shape memory element is extended along an axial direction and includes a first end fixed to the body and a second end opposite to the first end. Wherein, when a temperature of the shape memory element is below a predetermined temperature range, the shape memory element is in a first shape and the second end is positioned inside the opening, and when the temperature of the shape memory element is above the predetermined temperature range, the shape memory element is twisted to deform into a second shape, and the second end protrudes out of the opening.

In one embodiment of the invention, the electronic device further includes a supporting base connected to the second end, wherein the shape memory element is in a first shape and the supporting base is accommodated in the opening when a temperature of the shape memory element is below the predetermined temperature range, and the shape memory element is twisted to deform into the second shape when the temperature of the shape memory element is above the predetermined temperature range and drives the supporting base to rotate and partially protrudes out of the opening.

In one embodiment of the invention, the electronic device further includes a fixing component disposed between the body and the supporting base, wherein the supporting base is in close proximity to the body through the fixing component when the shape memory element is in the first shape, and the supporting base overcomes restraint of the fixing component and partially protrudes out of the body when the shape memory element deforms into the second shape.

In one embodiment of the invention, the fixing component includes a pair of magnets attracted to each other, respectively and oppositely disposed at the supporting base and the body and adapted to allow the supporting base and the body to be separatably fixed to each other.

In one embodiment of the invention, the fixing component includes a hook and a recess, respectively disposed at the supporting base and the body and adapted to allow the supporting base and the body to be separatably fixed to each other.

In one embodiment of the invention, the supporting base includes a slot to which the second end of the shape memory element is adapted to be engaged.

In one embodiment of the invention, the body includes a heat source and a thermal conducting component, wherein the thermal conducting component is between the heat source and the shape memory element.

In one embodiment of the invention, the supporting base includes a first edge and a second edge opposite to the first edge, wherein when the shape memory element deforms into the second shape, the first edge protrudes out of the opening, moving away from the bottom surface, and the second edge leans against the body.

In one embodiment of the invention, the predetermined temperature range is between 40°C and 65°C.

In one embodiment of the invention, a material of the shape memory element includes iron-based alloy, nickel-titanium alloy or copper-based alloy.

Based on the above, in the electronic device according to the invention, the supporting base is connected to the shape memory element, and the shape memory element may form a first shape when the temperature is below the predetermined temperature range to allow the supporting base to be accommodated in the opening, and the shape memory element is twisted to deform into a second shape when the temperature is above the predetermined temperature range so as to drive the supporting base to rotate. As such, when the temperature is above the predetermined temperature range, the supporting base may automatically rotate out of the bottom surface of the electronic device without providing electrical power, then the electronic device is lifted and supported by a desktop where the electronic device is placed, thus the heat dissipation of the electronic device is improved.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1 is a schematic three-dimensional view of an electronic device according to an embodiment of the invention.
FIG. 2 is a schematic cross-sectional view taken from a section line A-A shown in FIG. 1.
FIG. 3 is a schematic three-dimensional view of an electronic device according to an embodiment of the invention.
FIG. 4 is a cross-sectional schematic view taken along a section line A'-A' shown in FIG. 3.
FIG. 5 is a schematic view of a part of an electronic device according to an embodiment of the invention when a shape memory element is in a first shape.
FIG. 6 is a schematic view of a part of an electronic device according to an embodiment of the invention when a shape memory element is in a second shape.
FIG. 7 is a schematic cross-sectional view taken along a section line A-A shown in FIG. 1 of an embodiment of the invention.

### DESCRIPTION OF THE EMBODIMENTS

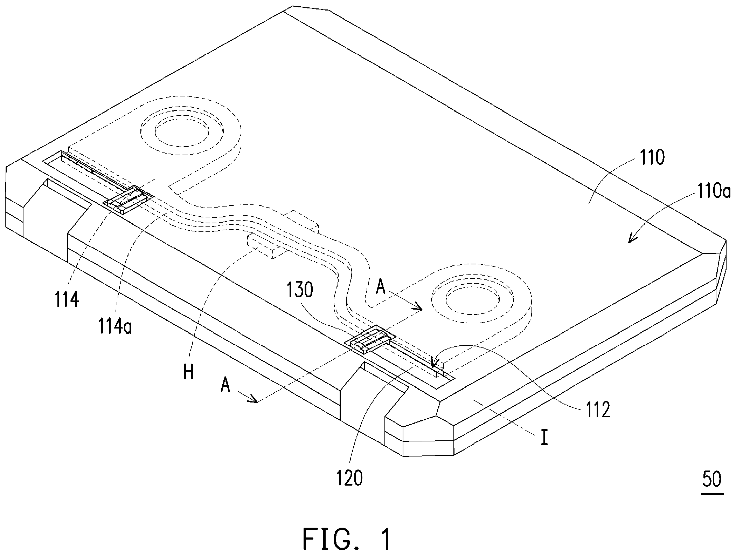

FIG. 1 is a schematic perspective view of an electronic device according to an embodiment of the invention. Referring to FIG. 1, a notebook computer is taken as an example for an electronic device 50 according to this embodiment, but it is not limited thereto. In other embodiments, the electronic device 50 may also be a tablet computer or the like. FIG. 1 is a schematic view illustrating a notebook computer according to an embodiment of the invention viewing upwardly from bottom of the case body. An electronic device 50 according to this embodiment includes a body 110, a shape memory element 120 and a supporting base 130. In this embodiment, the shape memory element 120 is a rectangular tabular element extended and disposed along an axial direction I, and one end thereof is fixed with the body 110, and the other end and the supporting base 130 are linked to each other. In this embodiment, for example, the body 110 of the electronic device 50 represents a case body of a notebook computer and includes an opening 112. The opening 112 also extends along the axial direction I and is adapted to accommodate the shape memory element 120 and the supporting base 130. In this embodiment, as shown in FIG. 1, two openings 112 are symmetrically disposed at two opposite sides of the bottom surface 110a of the body 110. However, the invention is not limited thereto. For example, the body 110 may include a single opening 112 or a plurality of openings 112 serving to accommodate the shape memory element 120 and the supporting base 130. For the disposition of the opening 112 may be symmetrical or asymmetrical, the invention is not limited thereto.

In addition, an electronic device 50 according to this embodiment further includes a heat source H and a thermal conducting component 114. The thermal conducting component 114 further includes a heat pipe 114a and is adapted to transfer heat generated from the heat source H to external environment of the electronic device 50. Since the thermal conducting component 114 and the heat source H are covered inside the body 110 of the electronic device 50, they are shown by dash lines in FIG. 1. The heat source H is an element for heat dissipation during the operation of the electronic device 50, such as a Central Processing Unit (CPU), a Random Access Memory (RAM) and so on, but the invention is not limited thereto. The thermal conducting component 114 may use, for example, a metal thermal conducting pipe, a heat dissipation fin or the like, but, in terms of forms and materials, the invention is not limited thereto. In addition, the thermal conducting component 114 is disposed between the heat source H and the shape memory element 120. By such arrangement, heat from the heat source H may be transferred to the shape memory element 120 through the thermal conducting component 114 and the heat pipe 114a.

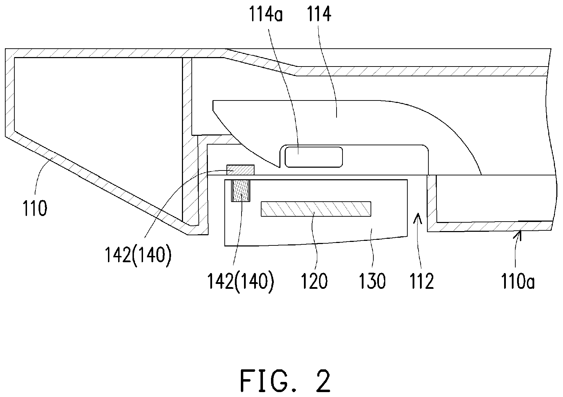

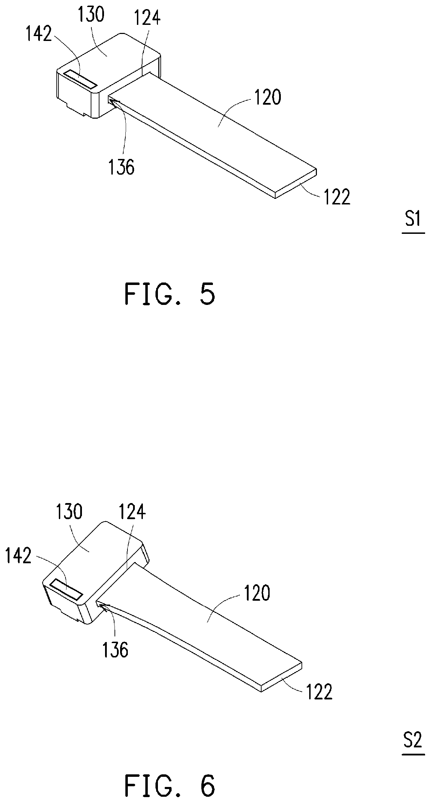

FIG. 2 is a schematic cross-sectional view taken from a section line A-A shown in FIG. 1. Referring to FIG. 2, in this embodiment, the shape memory element 120 is disposed below the thermal conducting component 114 and the heat pipe 114a and adapted to absorb heat of the thermal conducting component 114. Referring to FIG. 1 and FIG. 2, when a temperature of the shape memory element 120 is below a predetermined temperature range T, the shape memory element 120 is in a first shape S1 (as shown in FIG. 5). In this embodiment, a surface of the shape memory element 120 in the first shape S1 is substantially parallel to the bottom surface 110a of the body 110, and the supporting base 130 is accommodated inside the opening 112, and a surface of the supporting base 130 is also substantially parallel to the bottom surface 110a. Therefore, when the temperature is lower, the appearance of the electronic device 50 may remain flat which can be stored easily.

In addition, the electronic device 50 according to this embodiment may further includes a fixing component 140 disposed between the body 110 and the supporting base 130 and adapted to separatably fix the supporting base 130 into the opening 112 of the body 110. As shown in FIG. 2, in this embodiment, the fixing component 140 is a pair of magnets 142 attracted to each other respectively disposed on the supporting base 130 and the body 110. More specifically, in this embodiment, the magnet 142 fixed on the supporting base 130 may be disposed as N pole facing the body 110, and the magnet 142 fixed to the body 110 may be disposed as S pole facing the supporting base 130. However, the invention is not limited thereto. For example, the magnet 142 fixed to the supporting base 130 may be disposed as S pole facing the body 110, and the magnet 142 fixed to the body 110 is disposed as N pole facing the supporting base 130. In other aspects of embodiments of the invention, the fixing component 140 is disposed on the supporting base 130 and the body 110 and is fixed by a magnetic fixer including one being a magnet and the other being ferromagnetic material. For example, a magnet is disposed on the supporting base 130, and a structure including iron-nickel alloy, iron-cobalt alloy or the like is disposed relatively on the body 110, but the invention is not limited thereto. In addition to fixing the supporting base 130 more firmly, the fixing component 140 may help the supporting base 130 return to a position fast and accurately in a process in which the shape memory element 120 change its shape.

Wherein, in an embodiment of the invention, the shape memory element 120 may use shape memory alloy (SMA) of which a material may include iron-based alloy, nickel-titanium alloy or copper-based alloy, but the invention is not limited thereto. That is, any materials that may change its shape by temperature difference are within the scope of the invention.

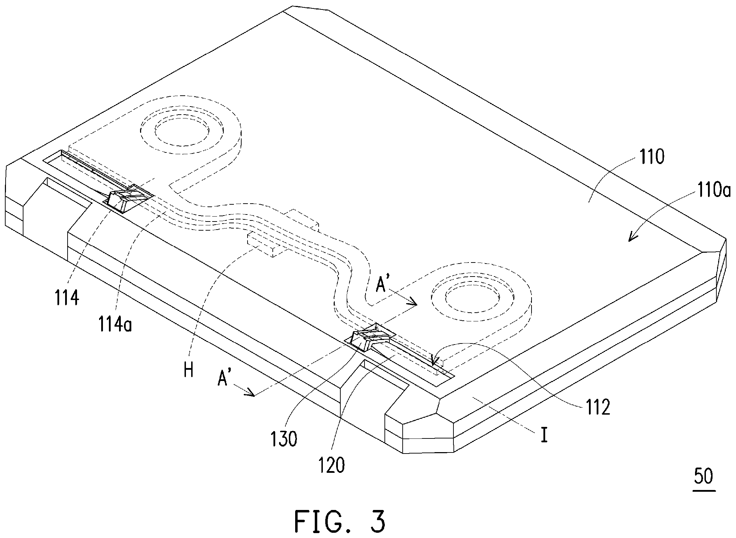

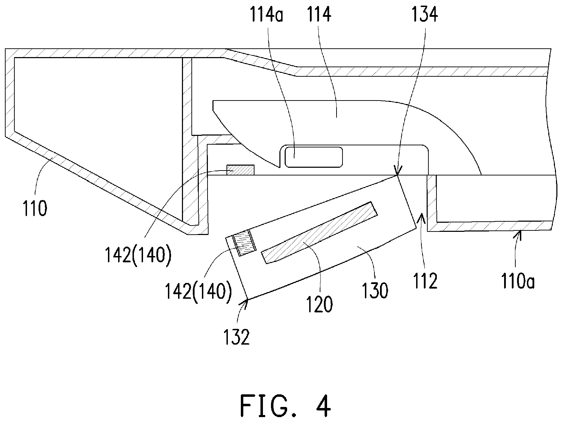

FIG. 3 is a three-dimensional schematic view of an electronic device according to an embodiment of the invention. FIG. 4 is a cross-sectional schematic view taken along a section line A'-A' shown in FIG. 3. Referring to FIG. 3, when a temperature of the shape memory element 120 is above the predetermined temperature range T, the shape memory element 120 forms a second shape S2 (as shown in FIG .6). More specifically, referring to FIG. 3 and FIG. 4, when heat generated by the heat source H causes excessively high operation temperature of the electronic device 50, the temperature of the shape memory element 120 is above the predetermined temperature range T through the transmission of the thermal conducting component 114, the shape memory element 120 is adapted to twist along the axial direction I. Since one end of the shape memory element 120 is fixed to the body 110, the twist of the shape memory element 120 may drive the supporting base 130, to which the other end is connected, to rotate relative to the axial direction I. As such, the shape memory element 120 deforms into the second shape S2, and the supporting base 130 overcomes restraint from a magnetic force of the pair of magnets 142 of the fixing component 140 to rotate away and partially protrudes out of the opening 112. In addition, the supporting base 130 includes a first edge 132 and a second edge 134. In this embodiment, the first edge 132 and the fixing component 140 are at the same side, and a position of the second edge 134 is relative to that of the first edge 132. When the shape memory element 120 deforms into a second shape S2, the second edge 134 is adapted to lean against the body 110, and the first edge 132 may move away from the bottom surface 110a of the body 110 relative to the second edge 134. Here, the first edge 132 protruding out of the opening 112 may be adapted to support the electronic device 50 on a flat surface (not shown in the figures), so as to improve the efficiency of heat dissipation.

FIG. 5 is a schematic view of a part of an electronic device according to an embodiment of the invention when a shape memory element is in a first shape. FIG. 6 is a schematic view of a part of an electronic device according to an embodiment of the invention when a shape memory element is in a second shape. To describe the members of this embodiment in more details, please referring to FIG. 5 and FIG. 6. FIG. 5 is a schematic view of the shape memory element 120 in the first shape S1, and FIG. 6 is a schematic view of the shape memory element 120 in the second shape S2. The shape memory element includes a first end 122 and a second end 124, wherein the first end 122 is adapted to be fixed to the body 110 of the electronic device 50, and the second end 124 is adapted to be linked to the supporting base 130 to drive the supporting base 130 to rotate. In addition, in one embodiment of the invention, the supporting base 130 further includes a slot 136 adapted to accommodate and engage the shape memory element 120, wherein a shape of the slot 136 and that of the second end 124 of the shape memory element 120 correspond to each other. Therefore, for the shape memory element 120 fixed by the slot 136, during the process in which the shape memory element 120 is heated to transform from the first shape S1 to the second shape S2, the supporting base 130 is driven to rotate by the shape memory element 120.

Regarding the determination of the predetermined temperature range T, in addition to the material of the shape memory element 120, different transition temperatures may be selected according to requirements. Further, in the processing of the shape memory element 120, the desired transition temperature range can be achieved through various heat processing. In one embodiment of the invention, the predetermined temperature range T of the shape memory element 120 is set to be between 40°C and 65°C. Then, when the electronic device 50 is close to a room temperature, that is, the temperature of the shape memory element 120 is below 40°C, the supporting base 130 is accommodated inside the opening 112 of the body 110; when the electronic device 50 has a higher operation temperature due to heat generated by computation of internal electronic elements, the process of the thermal conducting component 114 transferring heat allows the temperature of the shape memory element 120 to be above the predetermined temperature range T (i.e., the temperature is more than 65°C), and the shape memory element is twisted relative to the axial direction I, such that the supporting base 130 is driven to rotate. Therefore, it is achieved that the supporting base 130 may automatically lift and support the electronic device 50 when the temperature of the electronic device 50 is increased, and that the bottom surface of the electronic device 50 may facilitate air convection and have better heat dissipation efficiency.

The description about the change of operation temperature of the electronic device 50 according to this embodiment in a structural manner and in more details please referred from FIG. 1 to FIG. 6. In the embodiment of the invention, when the electronic device 50 is at the room temperature, or the temperature of the thermal conducting component 114 of the electronic device 50 is below the predetermined temperature range T, the operation temperature of the electronic device 50 may not be uncomfortable to an operator, and the operation at the temperature may not damage elements inside the electronic device 50. At this time, the shape memory element 120 is in the first shape S1, and the surface of the shape memory element 120 is parallel to the bottom surface 110a of the electronic device 50, such that the surface of the supporting base 130 is substantially parallel to the bottom surface 110a and is accommodated inside the opening 112, and the supporting base 130 is further in close proximity to the body 110 through the fixing component 140. When the electronic device 50 is operated for a longer time or performs works with greater operation load, the internal temperature of the electronic device 50 is thus increased, more efficient heat dissipation needs to be perform at this time, so as to protect the electronic elements inside the electronic device 50 and to further ensure an operation environment with safety and comfort for an operator. At this time, the shape memory element 120 is heated and the temperature thereof is above the predetermined temperature range T, and the shape memory element 120 is automatically twisted to deform into the second shape S2 and drives the supporting base 130 to rotate away from restraint of the fixing component 140. The first edgel32 of the supporting base 130 protrudes out of the bottom surface 110a relative to the body 110, and the supporting base 130 holds the electronic device 50 and includes a gap (not shown) between itself and the desktop (not shown), so as to promote air convection, thereby improving efficiency of heat dissipation.

Afterwards, when the temperature of the electronic device 50 is reduced due to heat dissipation or low workload (e.g., returning to the approximate room temperature), the shape memory element 120 is cooled down and the temperature thereof is reduced below the predetermined temperature range T, and the shape memory element 120 may be adapted to automatically return from the second shape S2 to the first shape S1 (i.e., return to the state in which the surface thereof is parallel to the bottom surface 110a of the electronic device 50), thereby driving the supporting base 130 to be rotated and return to be accommodated in the opening 112. In this case, since the electronic device 50 does not require additional heat dissipation, the supporting base 130 is automatically accommodated in the opening 112, such that it is easier to operate the electronic device 50, and easier for storage.

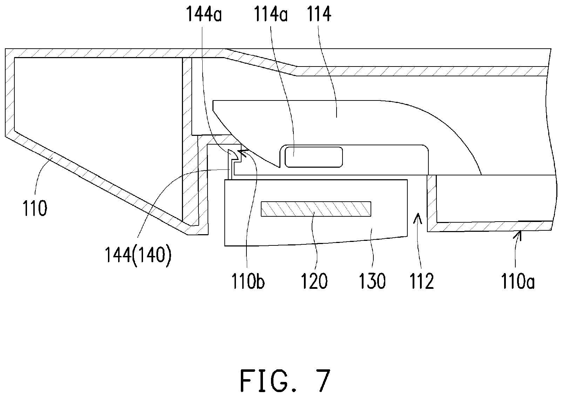

In another embodiment, the fixing component 140 may adapt a form of hook, as shown in FIG. 7. FIG. 7 is a schematic cross-sectional view taken along a section line A-A shown in FIG. 1 of an embodiment of the invention. Referring to FIG. 7, the fixing component 140 included in the supporting base 130 may be a hook 144 disposed on the supporting base 130 and including a protrusion 144a adapted to be engaged by a recess 110b of the body 110 of the electronic device 50. Wherein, when the temperature of the shape memory element 120 is above the predetermined temperature range T, the supporting base 130 may move away from the engagement of the hook 144 and the body 110 and thus rotate. The operation ways of the supporting base 130 and the shape memory element 120, which are the same as the above, are omitted here. Although the fixing component 140 is disclosed as above, a rotating spring or the like may also be adapted as a way of fixing the supporting base 130, the invention is not limited thereto.

In conclusion, the electronic device according to the invention may automatically move the supporting base out of the body of the electronic device in a rotating manner according to different operation temperatures. More specifically, the shape memory element of the electronic device according to the invention has different shapes when above or below the predetermined temperature range. Therefore, when the temperature of the electronic device is above a certain temperature, the shape memory element deforms and is twisted relative to an axial direction of its own. The twisting deformation drives the supporting base to rotate and protrude out of the body, and the protruding supporting base is adapted to lift and support the electronic device, such that the electronic device and the desktop may generate an airflow path for heat dissipation to improve the efficiency of heat dissipation. On the other hand, after the temperature of the electronic device is reduced to a certain temperature through cooling, the shape memory element may be changed from the second shape to the initial first shape and return and be accommodated into the opening of the electronic device. In this way, when heat dissipation is required due to increasing temperature, the supporting base of the electronic device automatically lift and support the electronic device; and when the temperature of the electronic device returns to a temperature which does not require heat dissipation, the supporting base according to the invention may automatically return to the original position. An additional temperature measurement and human resources for adjustment are not required in the entire operation process, and the purpose of dissipating, protecting of the internal elements of the electronic device and maintaining the comfort of users who operates the electronic device. In addition, the supporting base which automatically shrinks back may allow the electronic device to be easily accommodated.

## Claims

1. An electronic device (50), comprising:
a body (110), having an opening (112) at a bottom surface (110a) of the electronic device (50); and
a shape memory element (120), twistably disposed in the opening (112), the shape memory element (120) extending along an axial direction (I) and having a first end (122) fixed to the body (110) and a second end (124) opposite to the first end (122), wherein
the shape memory element (120) is in a first shape (S1) and the second end (124) is positioned inside the opening (112) when a temperature of the shape memory element (120) is below a predetermined temperature range (T), and
the shape memory element (120) is twisted along the axial direction (I) to deform into a second shape (S2) with the second end (124) protruding out of the opening (112) when the temperature of the shape memory element (120) is above the predetermined temperature range (T),
wherein the axial direction (I) is parallel to the bottom surface (110a) of the electronic device.

2. The electronic device of claim 1, further comprising a supporting base (130), connected to the second end (124), wherein
the shape memory element (120) is in the first shape (S1) and the supporting base (130) is accommodated in the opening (112) when a temperature of the shape memory element (120) is below the predetermined temperature range (T); and
the shape memory element (120) is twisted to deform into the second shape (S2), driving the supporting base (130) to rotate and partially protrude out of the opening (112) when the temperature of the shape memory element (120) is above the predetermined temperature range (T).

3. The electronic device of claim 2, further comprising a fixing component (140), disposed between the body (110) and the supporting base (130), wherein
the supporting base (130) is in close proximity to the body (110) through the fixing component (140) when the shape memory element (120) is in the first shape (S1); and
the supporting base (130) overcomes restraint of the fixing component (140) and partially protrudes out of the body (110) when the shape memory element (120) deforms into the second shape (S2).

4. The electronic device of claim 3, wherein the fixing component (140) comprises a pair of magnets (142) attracted to each other, respectively and correspondingly disposed at the supporting base (130) and the body (110) and adapted to allow the supporting base (130) and the body (110) to be separatably fixed to each other.

5. The electronic device of claim 3, wherein the fixing component (140) comprises a hook (144) and a recess (110b), respectively disposed at the supporting base (130) and the body (110) and adapted to allow the supporting base (130) and the body (110) to be separatably fixed to each other.

6. The electronic device of claim 2, wherein the supporting base (130) comprises a slot (136), and the second end (124) of the shape memory element (120) is adapted to be engaged in the slot (136).

7. The electronic device of claim 1, wherein the body (110) comprises a heat source (H) and a thermal conducting component (114), wherein the thermal conducting component (114) is between the heat source (H) and the shape memory element (120).

8. The electronic device of claim 2, wherein
the supporting base (130) comprises a first edge (132) and a second edge (134) opposite to the first edge (132); and
when the shape memory element (120) deforms into the second shape (S2), the first edge (132) protrudes out of the opening (112), moving away from the bottom surface (110a), and the second edge (134) leans against the body (110).

9. The electronic device of claim 1, wherein the predetermined temperature range (T) is between 40°C and 65°C.

10. The electronic device of claim 1, wherein a material of the shape memory element (120) comprises iron-based alloy, nickel-titanium alloy or copper-based alloy.

## Patentansprüche

1. Elektronische Vorrichtung (50), umfassend:
einen Körper (110) mit einer Öffnung (112) an einer Bodenfläche (110a) der elektronischen Vorrichtung (50); und
ein Formgedächtniselement (120), das verdrehbar in der Öffnung (112) angeordnet ist, wobei sich das Formgedächtniselement (120) entlang einer axialen Richtung (I) erstreckt und ein erstes Ende (122), das an dem Körper (110) befestigt ist, und ein zweites Ende (124) gegenüber dem ersten Ende (122) aufweist, wobei
das Formgedächtniselement (120) eine erste Form (S1) hat und das zweite Ende (124) innerhalb der Öffnung (112) positioniert ist, wenn eine Temperatur des Formgedächtniselements (120) unter einem vorbestimmten Temperaturbereich (T) liegt, und
das Formgedächtniselement (120) entlang der axialen Richtung (I) verdreht wird, um sich in eine zweite Form (S2) zu verformen, bei der das zweite Ende (124) aus der Öffnung (112) herausragt, wenn die Temperatur des Formgedächtniselements (120) über dem vorbestimmten Temperaturbereich (T) liegt,
wobei die axiale Richtung (I) parallel zu der Bodenfläche (110a) der elektronischen Vorrichtung ist.

2. Elektronische Vorrichtung nach Anspruch 1, ferner umfassend eine Stützbasis (130), die mit dem zweiten Ende (124) verbunden ist, wobei
das Formgedächtniselement (120) die erste Form (S1) hat und die Stützbasis (130) in die Öffnung (112) aufgenommen ist, wenn eine Temperatur des Formgedächtniselements (120) unter dem vorbestimmten Temperaturbereich (T) liegt; und
das Formgedächtniselement (120) verdreht wird, um sich in die zweite Form (S2) zu verformen, wodurch die Stützbasis (130) getrieben wird, sich zu drehen und teilweise aus der Öffnung (112) herauszuragen, wenn die Temperatur des Formgedächtniselements (120) über dem vorbestimmten Temperaturbereich (T) liegt.

3. Elektronische Vorrichtung nach Anspruch 2, ferner umfassend eine Befestigungskomponente (140), die zwischen dem Körper (110) und der Stützbasis (130) angeordnet ist, wobei
die Stützbasis (130) sich durch die Befestigungskomponente (140) in nächster Nähe zu dem Körper (110) befindet, wenn das Formgedächtniselement (120) die erste Form (S1) hat; und
die Stützbasis (130) ein Zurückhalten durch die Befestigungskomponente (140) überwindet und teilweise aus dem Körper (110) herausragt, wenn sich das Formgedächtniselement (120) in die zweite Form (S2) verformt.

4. Elektronische Vorrichtung nach Anspruch 3, wobei die Befestigungskomponente (140) ein Paar Magneten (142) umfasst, die sich jeweils einander anziehen, und entsprechend an der Stützbasis (130) und dem Körper (110) angeordnet sind und dazu angepasst sind, zu ermöglichen, dass die Stützbasis (130) und der Körper (110) trennbar aneinander befestigt sind.

5. Elektronische Vorrichtung nach Anspruch 3, wobei die Befestigungskomponente (140) einen Haken (144) und eine Aussparung (110b) umfasst, die jeweils an der Stützbasis (130) und dem Körper (110) angeordnet sind und dazu angepasst sind, zu ermöglichen, dass die Stützbasis (130) und Körper (110) trennbar aneinander befestigt sind.

6. Elektronische Vorrichtung nach Anspruch 2, wobei die Stützbasis (130) einen Schlitz (136) umfasst, und das zweite Ende (124) des Formgedächtniselements (120) dazu angepasst ist, mit dem Schlitz (136) in Eingriff zu stehen.

7. Elektronische Vorrichtung nach Anspruch 1, wobei der Körper (110) eine Wärmequelle (H) und eine wärmeleitende Komponente (114) umfasst, wobei sich die wärmeleitende Komponente (114) zwischen der Wärmequelle (H) und dem Formgedächtniselements (120) befindet.

8. Elektronische Vorrichtung nach Anspruch 2, wobei die Stützbasis (130) eine erste Kante (132) und eine zweite Kante (134) gegenüber der ersten Kante (132) umfasst; und
wenn sich das Formgedächtniselement (120) in die zweite Form (S2) verformt, die erste Kante (132) aus der Öffnung (112) herausragt und sich von der Bodenfläche (110a) wegbewegt, und die zweite Kante (134) sich gegen den Körper (110) lehnt.

9. Elektronische Vorrichtung nach Anspruch 1, wobei der vorbestimmte Temperaturbereich (T) zwischen 40 °C und 65 °C liegt.

10. Elektronische Vorrichtung nach Anspruch 1, wobei ein Material des Formgedächtniselements (120) eine Legierung auf Eisenbasis, eine Nickel-Titan-Legierung oder eine Legierung auf Kupferbasis umfasst.

## Revendications

1. Dispositif électronique (50), comprenant :
un corps (110), ayant une ouverture (112) à une surface inférieure (110a) du dispositif électronique (50) ; et
un élément de mémoire de forme (120), disposé de manière à pouvoir subir une torsion dans l'ouverture (112), l'élément de mémoire de forme (120) s'étendant le long d'une direction axiale (I) et ayant une première extrémité (122) fixée au corps (110) et une deuxième extrémité (124) à l'opposé de la première extrémité (122), dans lequel
l'élément de mémoire de forme (120) est dans une première forme (S1) et la deuxième extrémité (124) est positionnée à l'intérieur de l'ouverture (112) lorsqu'une température de l'élément de mémoire de forme (120) est au-dessous d'une plage de températures prédéterminée (T), et
l'élément de mémoire de forme (120) subit une torsion le long de la direction axiale (I) pour se déformer dans une deuxième forme (S2) avec la deuxième extrémité (124) faisant saillie hors de l'ouverture (112) lorsque la température de l'élément de mémoire de forme (120) est au-dessus de la plage de températures prédéterminée (T),
dans lequel la direction axiale (I) est parallèle à la surface inférieure (110a) du dispositif électronique.

2. Dispositif électronique selon la revendication 1, comprenant en outre une base de support (130), reliée à la deuxième extrémité (124), dans lequel
l'élément de mémoire de forme (120) est dans la première forme (S1) et la base de support (130) est logée dans l'ouverture (112) lorsqu'une température de l'élément de mémoire de forme (120) est au-dessous de la plage de températures prédéterminée (T) ; et
l'élément de mémoire de forme (120) subit une torsion pour se déformer dans la deuxième forme (S2), en amenant la base de support (130) à tourner et à faire partiellement saillie hors de l'ouverture (112) lorsque la température de l'élément de mémoire de forme (120) est au-dessus de la plage de températures prédéterminée (T).

3. Dispositif électronique selon la revendication 2, comprenant en outre un composant de fixation (140), disposé entre le corps (110) et la base de support (130), dans lequel
la base de support (130) est en étroite proximité du corps (110) à travers le composant de fixation (140) lorsque l'élément de mémoire de forme (120) est dans la première forme (S1) ; et
la base de support (130) surmonte la retenue du composant de fixation (140) et fait partiellement saillie hors du corps (110) lorsque l'élément de mémoire de forme (120) se déforme dans la deuxième forme (S2).

4. Dispositif électronique selon la revendication 3, dans lequel le composant de fixation (140) comprend une paire d'aimants (142) attirés l'un vers l'autre, respectivement disposés en correspondance à la base de support (130) et au corps (110) et aptes à permettre à la base de support (130) et au corps (110) d'être fixés l'un à l'autre de manière à pouvoir être séparés.

5. Dispositif électronique selon la revendication 3, dans lequel le composant de fixation (140) comprend un crochet (144) et un évidement (110b), respectivement disposés à la base de support (130) et au corps (110) et aptes à permettre à la base de support (130) et au corps (110) d'être fixés l'un à l'autre de manière à pouvoir être séparés.

6. Dispositif électronique selon la revendication 2, dans lequel la base de support (130) comprend une fente (136), et la deuxième extrémité (124) de l'élément de mémoire de forme (120) est apte à être engagée dans la fente (136).

7. Dispositif électronique selon la revendication 1, dans lequel le corps (110) comprend une source de chaleur (H) et un composant de conduction thermique (114), dans lequel le composant de conduction thermique (114) est entre la source de chaleur (H) et l'élément de mémoire de forme (120) .

8. Dispositif électronique selon la revendication 2, dans lequel
la base de support (130) comprend un premier bord (132) et un deuxième bord (134) à l'opposé du premier bord (132) ; et
lorsque l'élément de mémoire de forme (120) se déforme dans la deuxième forme (S2), le premier bord (132) fait saillie hors de l'ouverture (112), en s'éloignant de la surface inférieure (110a), et le deuxième bord (134) s'appuie contre le corps (110).

9. Dispositif électronique selon la revendication 1, dans lequel la plage de températures prédéterminée (T) est entre 40 °C et 65 °C.

10. Dispositif électronique selon la revendication 1, dans lequel un matériau de l'élément de mémoire de forme (120) comprend un alliage à base de fer, un alliage nickel titane ou un alliage à base de cuivre.
